# EUROPEAN PATENT SPECIFICATION

(11) **EP 2 306 517 B1**
(45) Date of publication and mention of the grant of the patent: **02.11.2016**
(21) Application number: 10184411.6
(22) Date of filing: 30.09.2010
(51) Int. Cl.: H01L 23/544

(54) **Indexing of electronic devices using marks distributed on two coupled chips**
Indexierung von elektronischen Vorrichtungen mittels auf zwei verkoppelten Chips verteilter Markierungen
Indexation de dispositifs électroniques avec marques distribuées sur deux puces couplées ensemble

(30) Priority: 30.09.2009 IT MI20091684
(43) Date of publication of application: 06.04.2011
(73) Proprietor: STMicroelectronics Srl, 20864 Agrate Brianza (IT)
(72) Inventor: Freguglia, Alessandro, I-20021 Bollate (MI) (IT); Pividori, Luca, I- 24035 Curno (BG) (IT)
(74) Representative: Cerbaro, Elena

(56) References cited:
- WO-A1-00/33360
- WO-A1-01/39269
- JP-A- H04 340 214
- JP-A- 2007 048 989
- JP-A- 2007 081 123
- US-A1- 2003 127 718
- US-A1- 2003 166 313

## Description

The solution according to one or more embodiments of the present invention generally relates to electronic devices, in particular, such solution relates to the indexing of the electronic devices.

Electronic devices are typically integrated in chips of semiconductor material. The chips are formed in large numbers in a wafer of semiconductor material through a production process typically performed in a sequence of steps. At the end of this process, the wafer includes a plurality of chips (equal to each other) that are then separated by a cutting operation.

In particular, some classes of electronic devices are formed by two chips coupled to each other.

For example, a MEMS (Micro-Electro-Mechanical System) device is formed by a sensor chip, wherein there is implemented an electro-mechanical sensor, and by a cap chip, used to cover the sensor in order to protect it form the external environment.

The production process of such class of electronic devices involves the formation of a plurality of sensor chips on a wafer, and the formation of a corresponding plurality of cap chips on another wafer. A composite wafer is obtained from the union of these two wafers by overlapping them. The MEMS devices are then obtained by cutting the composite wafer at each pair of sensor chip and cap chip.

Should the MEMS devices be found defective before or during their use, they are returned to the manufacturer in order to carry out a failure analysis; therefore, the possibility of tracing the original position of the sensor chip in the corresponding wafer is of strategic importance for the management of the quality of the production process. In fact, functional parameters, performance and reliability of each sensor chip may vary even considerably as a function of its position in the wafer. For this reason, it is important for the manufacturer to know where to intervene for improving the quality of the production process.

For such purpose, it is known in the state of the art to provide on each sensor chip an index being indicative of its position within the corresponding wafer.

In particular, with the increase of the size of the wafers and with the increase of the integration capability of the electronic devices, each step of the production process of the sensor chips through a proper photolithographic mask may no more be performed in only one step (so-called "one shot" mode) over the entire area of the wafer, but it is typically performed step by step (so-called "stepper shot" mode) on different portions of the wafer; at each step, the mask acts on a corresponding area of the wafer wherein there will be made, at the end of the process, a corresponding subset of sensor chips; the same operation is repeated until applying the same mask on the entire area of the wafer. In this case, the index of each sensor chip is formed by two portions. A first index portion (obtained through a specific mask) identifies the position of the sensor chip within the corresponding area of the wafer (being equal for the sensor chips placed in corresponding positions in the different areas because of the repeated use of the same mask). A second portion of the index (obtained by known techniques of direct writing on wafer, for example, laser-based) then identifies the area of the wafer in which the sensor chip is formed.

In any case, the integration capability of the sensor chips required by the current design specifications is such that the number of sensor chips integrated in each wafer grows significantly; therefore, the number of sensor chips to be indexed being greater and greater, the index will be longer and longer. However, an increasing length of the index is obviously inconsistent with the miniaturization of the electronic devices because the length of the index may significantly affect the size of the sensor chips and, ultimately, of the corresponding electronic devices.

The problem is exacerbated by the fact that often, for facilitating the identification of the index portions, it is preferred to write the two index portions in different regions of the sensor chip. Since such regions must be properly spaced from the active areas of the sensor chip for avoiding damages during the writing of the index, this technique causes further increases in the size of the electronic devices.

Other indexing techniques are known in the art.

For example, the document JP 2007 081123 discloses a chip being provided with a chip position identification pattern including information indicating the positions of a plurality of chip patterns in a reticle to be used in stepper lithography, and other information indicating the positions of exposure shots repeated across the semiconductor wafer. Such document does not face nor solve the above-mentioned problems relating to excessively long indexes with respect to the chip size.

The document US 2003/166313 discloses a semiconductor element mounting method providing for the possibility of superimposing different chips to each other at a wafer level , wherein the chips may be provided with marks.

The document US 2003/127718 discloses a semiconductor component and a method for identifying a semiconductor component that comprises at least one semiconductor substrate equipped with electronic/electromechanical components, which semiconductor substrate - except for its leads - is embedded in a housing part made of plastic. More specifically, a cap piece is provided with an identifier composed of a pattern of notch-like recesses. The identifier contains a code, e.g. a binary code, with which the original position of the semiconductor substrate on the base substrate (wafer from which it is diced) can be identified. The identifier can be read by injecting an ultrasonic wave by means of an ultrasonic device that comprises an ultrasonic transmitter and an ultrasonic receiver.

The document WO 01/39269 discloses a system for making small modifications to the pattern in standard processed semiconductor devices, such modifications being made to create a small variable part of the pattern against a large constant part of the same pattern. More specifically, it shows how two code-writing modules can be used to program sixteen identical dies (provided in groups of differently oriented dies) in a single stepper field.

JP2007048989 discloses a method for displaying product information according to product information of a semiconductor device, even if the volume of the product information is increased. A display direction of one character mark added next to a cathode band on the surface of a sealing body of a diode indicates the product information of the individual diode. Adding one character mark in a direction depending on the product information increases a type of indication by varying the direction of the mark even for the small diode.

JP04340214 discloses two chip patterns formed in a reticle while wafer code areas are formed on the four comers of these patterns with a mirror symmetry between the wafer code areas on the two chip patterns. Next, e.g. liquid crystal variable pattern formation device are manufactured on the wafer code areas so that the liquid crystal layers may be selectively impressed with a voltage through a wiring from electrode pads provided on the end part of the reticle so as to shape a transmitting light after the pattern formed by the liquid crystal layers. Through these procedures, the wafer identification codes of IC chips can be given to respective chips without causing the control of problem and throughput at all.

WO0033360 discloses an apparatus for use in manipulating one or more IC die through testing after they have been cut from the original wafer. A carrier supports the die during the transport, testing, and/or final application. A tracking mechanism may be added to the carrier. As each die is loaded into the carrier, information concerning that die (*e.g*., the location of the die on the wafer) is stored in a tracking label on the carrier. Optionally, an identification mark ID maybe applied to the backside of the die residing within the carrier.

In its general terms, the solution according to one or more embodiments of the present invention is based on the idea of distributing the index on different chips concurring to the formation of the electronic devices.

In particular, several aspects of the solution according to an embodiment of the invention are set forth in the independent claim.

Advantageous features of the same solution are indicated in the dependent claims.

More specifically, one aspect of the solution according to an embodiment of the invention proposes a method for indexing electronic devices. The method includes the steps of forming a plurality of first chips in a first wafer, forming a plurality of seconds chips in a second wafer, forming the electronic devices by coupling each first chip with a corresponding second chip, and forming an index on each electronic device; the index is indicative of a position of the corresponding first chip in the first wafer. In the solution according to an embodiment of the invention, the step of forming an index includes forming a first portion of the index on the first chip, and forming a second portion of the index on the second chip.

Another aspect, not forming part of the claimed invention, proposes a corresponding electronic device.

The solution according to one or more embodiments of the invention, as well as further features and the advantages thereof, will be best understood with reference to the following detailed description, given purely by way of a non-restrictive indication, to be read in conjunction with the accompanying drawings (wherein corresponding elements are denoted with equal or similar references, and their explanation is not repeated for the sake of exposition brevity). In this regard, it is expressly intended that the figures are not necessarily drawn to scale and that, unless otherwise indicated, they are simply used to conceptually illustrate the described structures and procedures. In particular:
FIG. 1 schematically shows the structure obtained at an intermediate step of a production process of MEMS devices known in the state of the art;
FIG.2 shows, in a simplified way, an indexing method of the MEMS devices of FIG. according to an embodiment of the present invention;
FIG.3 schematically shows an implementation of the indexing method of FIG.2 according to an embodiment of the present invention;
FIG.4A and FIG.4B schematically show a plant view and a cross-section view, respectively, of a MEMS device implementing the indexing method described in FIG.3 at a step of a manufacturing process thereof;
FIG.5A and FIG.5B schematically show a plant view and a cross-section view, respectively, of the MEMS device of FIG.4A at another step of a manufacturing process thereof; and
FIG.6A and 6B schematically show an implementation of the indexing method of FIG.2 according to another embodiment of the invention.

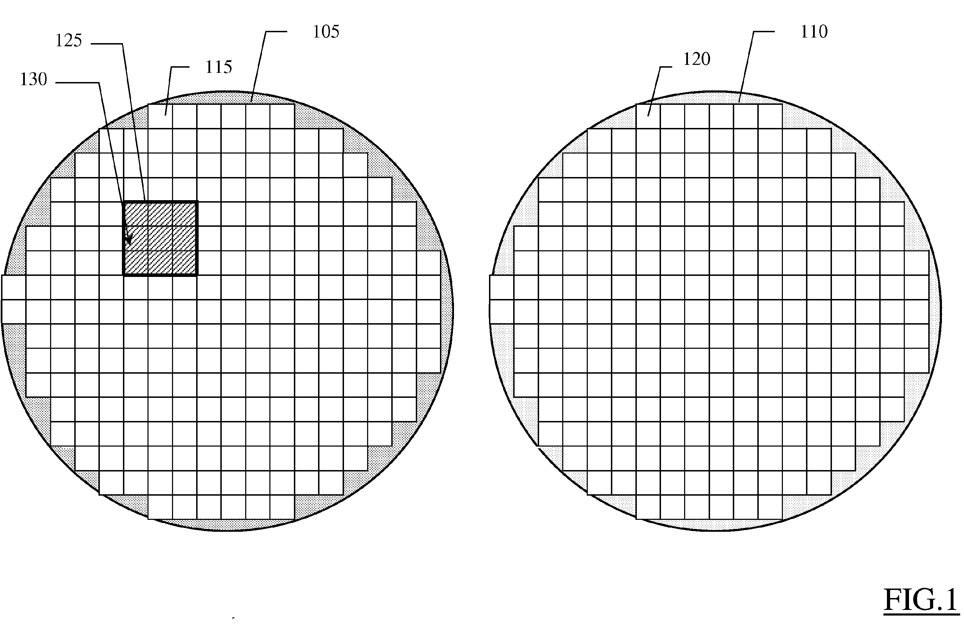

Considering in particular FIG.1, there is schematically shown the structure obtained at an intermediate step of a production process of MEMS devices known in the state of the art. In particular, the MEMS devices are formed on two wafers, a sensor wafer 105 and a cap wafer 110, including a plurality of electronic sensors (each one of them defining a corresponding sensor chip 115 once cut) and a plurality of caps (each one of them defining a corresponding cap chip 120 for a sensor chip 115 once cut), respectively.

The cap chips 120 are formed on the cap wafer 110 through the use of proper masks (not shown in the figure) in the one shot mode (that is, each mask covers a whole surface of the cap wafer 110). Instead, the sensor chips 115 are not formed on the wafer 105 in the one shot mode; in fact, the sensor chips 115, including electronic and mechanical circuits inside them, are more complex to implement than the cap chips 120 are, since they require a high integration capability. Such integration may not be effective if the wafer size increases, for the same process masks being used; the masks are then applied in an area 125 of the sensor wafer 105, which identifies a stepper: within each region 125 a subset of sensor chips 130 is formed according to the classic procedure (only nine shown in the figure for simplicity, but in very larger number in reality). Repeating such operations also for the other areas of the surface of the sensor wafer 105, it is obtained that on the whole surface of the sensor wafer 105 the desired plurality of sensor chips 115 will be formed.

At this point, the cap wafer 110 is inverted and superimposed on the sensor wafer 105 (obtaining a composite wafer, not shown in the figure) so as to cover each sensor chip 115 with the corresponding cap chip 120; each cap chip 120 is then bonded to the corresponding sensor chip 115.

Then, the composite wafer, being obtained from the union of the sensor wafer 105 with the cap wafer 110, is cut at each sensor chip 115, thus obtaining the desired MEMS devices.

Each MEMS device is identified by an index that identifies the position of its sensor chip 115 in the sensor wafer 105, and thus also of its cap chip 120 in the cap wafer 110.

In the solution according to an embodiment of the present invention (as described in detail below) such index is distributed partly on the sensor chip 115 and partly on the cap chip 120.

In this way, each one of the sensor chip 115 and the cap chip 120 has a corresponding index portion, which takes an area of the chip 115, 120 being certainly lower than that taken by the whole index only on the sensor chip 115; therefore, the minimization of the size of the sensor chip 115, and hence of the whole MEMS device, is not penalized.

Furthermore, the index portion being written on the cap chip 120 does not pose any problem of damage to the sensor chip 115 during the writing step.

Finally, the solution according to the described embodiment of the invention facilitates the localization of the two index portions without the need of increasing the size of the sensor chip 115.

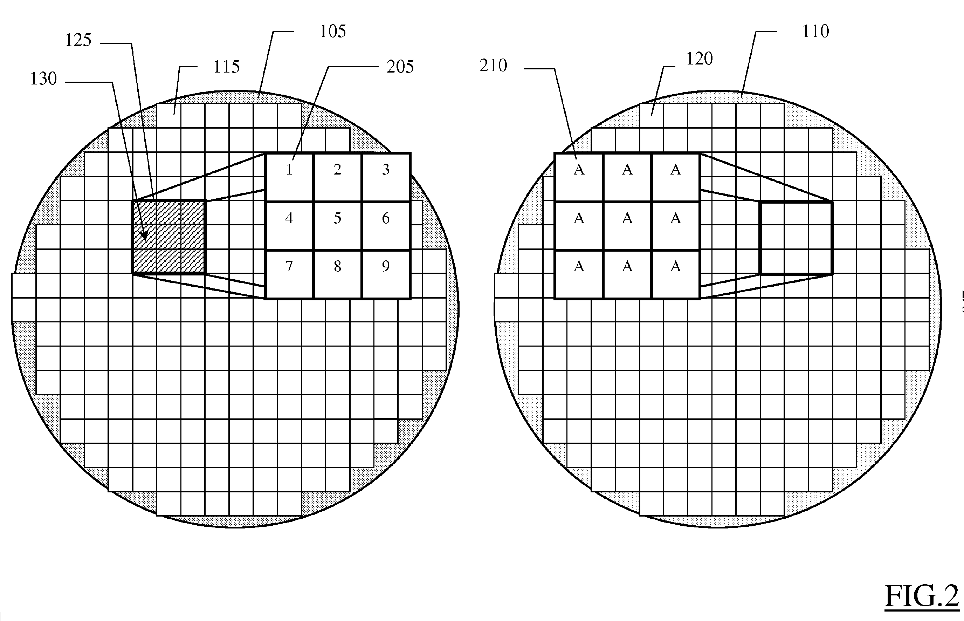

Turning now to FIG.2, there is shown, in a simplified way, an indexing method of the MEMS devices of FIG. 1 according to an embodiment of the present invention.

On each sensor chip 115 there is written a first index portion 205 that identifies the sensor chip 115 within the corresponding area 125; in order to illustrate the invention conceptually, in FIG.2 such index is represented exemplarily by numbers (1, 2, 3, 4, 5, 6, 7, 8, 9) corresponding to the limited number (nine, precisely) of sensor chips 115 represented in an exemplary way in each area 125. Such first index portion 205 is the same for the sensor chips 115 (of the various subsets 130) that are located in the same position within the corresponding area 125.

On each cap chip 120 there is written a second index portion 210 (represented, for simplicity by letters A, B, C, and so on) being indicative of a position of the area 125 of the corresponding subset of the sensor chips 130 in the sensor wafer 105; such second index portion 210 is the same for the cap chips 120 whose sensor chips 115 of a same subset 130 are included in a same area 125. It is noted that since the composite wafer is obtained by overturning the cap wafer 110 and overlapping it to the sensor wafer 105, the second index portions 210 may be written in areas of the cap wafer 110 located in mirror positions with respect to the positions of the areas 125 in the sensor wafer 105.

Each MEMS device is therefore identified by the first index portion 205 of its sensor chip 115 (indicating the position of the sensor chip 115 of the subset 130 within the corresponding area 125) and by the second index portion 210 of its cap chip 120 (indicating the position of the area 125 of the subset 130 of sensor chips within the sensor wafer 105). For example, the index A4 will indicate the fourth sensor chip 115 of a specific area 125, B3 the third sensor chip 115 of another specific area 125, C1 the first sensor chip 115 of a further specific area 125, and so on.

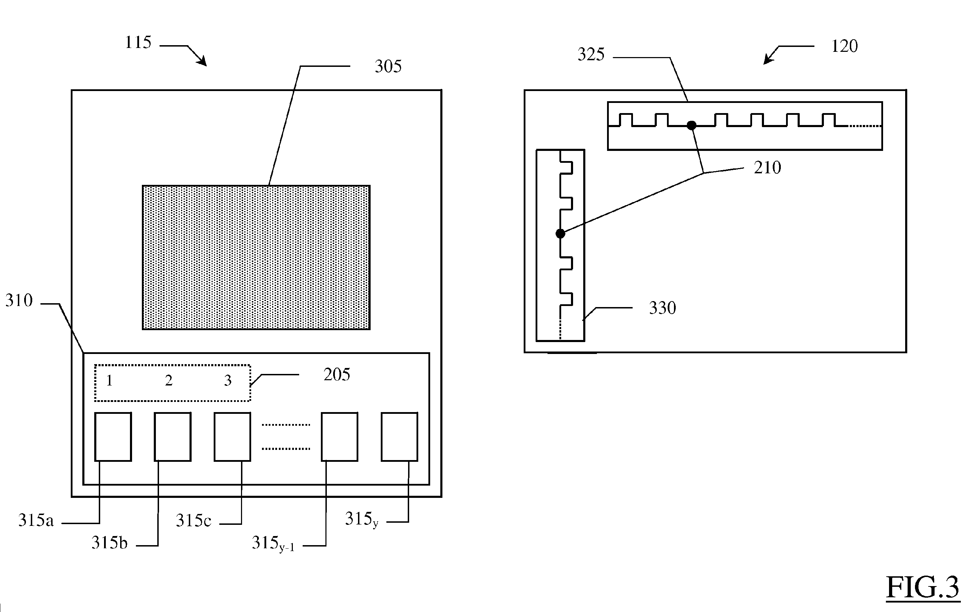

Turning now to FIG.3, there is schematically shown an implementation of the indexing method of FIG.2 according to an embodiment of the present invention.

In particular, in FIG.3 there is shown an implementation of the indexing method of FIG.2 of the generic sensor chip 115 (leftward), and the corresponding cap chip 120 (both the sensor chip 105 and the cap chip 120 being depicted in a plan view for simplicity).

The sensor chip 115 includes an active section 305 in which there is formed the electro-mechanical device, and a terminal section 310 in which there is formed a plurality of contacts (315a, 315b, 315c, 305_{y-1}, 315_{y}) being adapted to couple the active area 305 with an external device (not shown in the figure).

In a known manner, the cap chip 120 covers the whole active section 305 (so as to protect the electro-mechanical device), but not the terminal section 310 (so as to leave uncovered the contacts 315a, 315b, 315c, 305_{y-1}, 315_{y}).

The first index portion 205 on the sensor chip 115 is formed by a set of digits (for example, three); such digits are written in the terminal section 310, with each digit near a corresponding contact (for example, the first three contacts 315a, 315b, 315c). In the example in the figure, the first index portion 205 has the value 123 (for indicating the one-hundred-twenty-third sensor chip 115 in the corresponding area).

The second index portion 210 on the cap chip 120 instead implements a (row and column) coordinates system being adapted to identify the position of the corresponding area of the sensor wafer.

A row coordinate of the second index portion 210 is obtained from a row string 325 including a plurality of row dots (for example, 1,000 dots with a diameter of 5µm and a spacing of 10µm); the value of the row coordinate is defined in the string 325 by the position of a missing dot.

Similarly, a column coordinate is obtained from a column string 330 including a plurality of column dots: the value of the column coordinate is defined in the string 330 by the position of a missing point.

In the example in the figure, both the row string 325 and the column string 330 have a missing dot in the position 2; therefore, the coordinates forming the second index portion 210 are (2;2), indicating the area in the second row and in the second column of the sensor wafer.

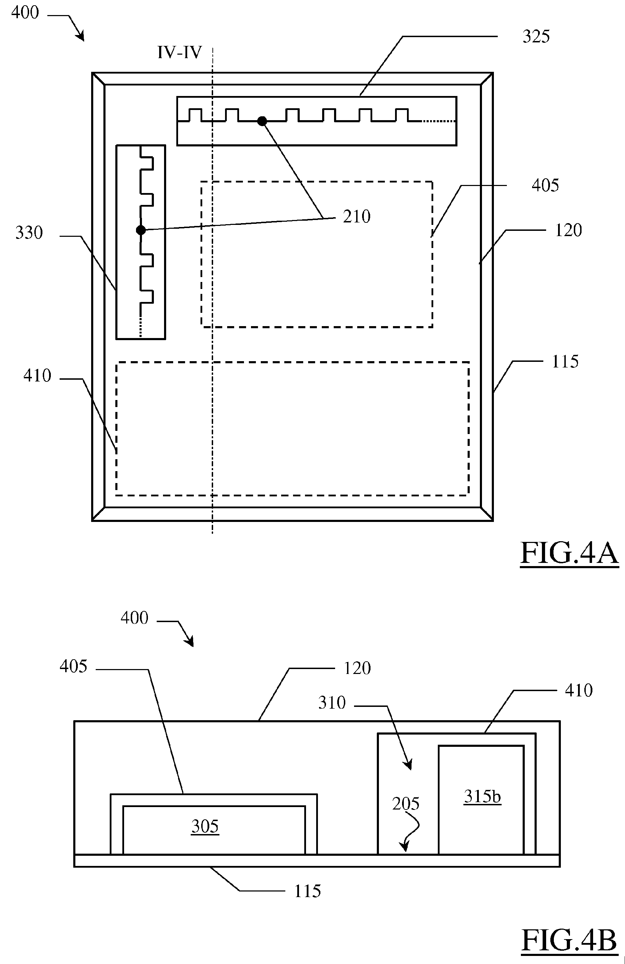

FIG.4A and FIG.4B schematically show a MEMS device 400 implementing the indexing method described in FIG.3 at a step of a manufacturing process thereof; particularly, FIG.4A shows the MEMS device 400 in plant view and FIG.4B shows a cross-section view of the same MEMS device 400 along the IV-IV axis of FIG.4A. In this phase, each cap chip 120 of the cap wafer is superimposed to the corresponding sensor chip 115 so as to cover it completely (in the following, only one sensor chip 115 and one cap chip 120 will be considered for simplicity, but it is clear that the MEMS devices are formed at a wafer level concurrently). As can be seen, a rear part of the cap chip 120 facing the sensor chip 115 is provided with two blind recesses 405 and 410; the recesses 405 and 410 are both formed (in the cap wafer) in a known manner at a proper step of the production process (e.g., before or after forming the second index portions 210). The recess 405 completely covers the active section 305 of the sensor chip 115, whereas the recess 410 completely covers the terminal section 310 thereof that include the contacts (whose only the contact 315b is visible) and the first index portion 205 - with the recess 410 that is deeper than the recess 405. Therefore, at such intermediate condition, only the second index portion 210 of the MEMS device 400 is visible (while the first index portion 205 is covered by the cap chip 120).

A front of the cap chip 120 associated to the recess 410 is then subjected to a (known) localised Chemical Mechanical Polishing/Planarization operation (or other similar or equivalent operations) acting selectively thereon, until the 410 recess is opened.

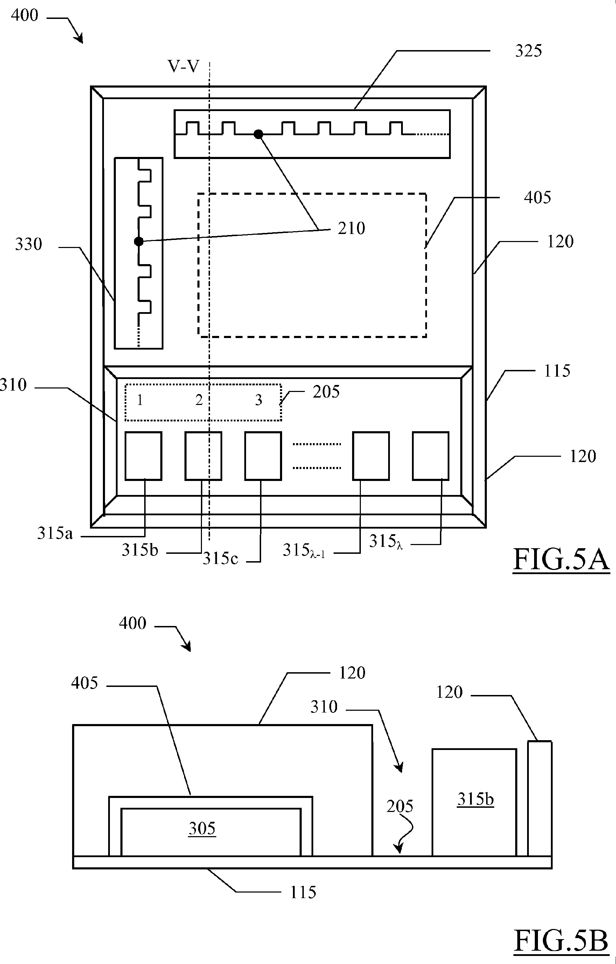

In this way, as visible in FIG.5A and FIG.5B (schematically showing the same MEMS device 400 at another step of its manufacturing process in plan view and in cross-section view along the V-V axis of FIG.5A, respectively) the terminals section 310 and the first index portion 205 of the sensor chip 115 are uncovered.

Alternatively, it is possible to perform the Chemical Mechanical Polishing/Planarization operation on the whole cap wafer (thus making the production process easier), by stopping it (after the recess 410 has been opened) before reaching the recess 405. In this case, the second index portion 210 is formed on the cap chip 120 after its planarization (at the level of the cap wafer).

Anyway, regardless of the disclosed exemplary and not limiting production processes being usable to make the MEMS device 400, the MEMS device 400 thereby obtained is such that the index portion 205 formed in the sensor chip 115 and the index portion 210 formed in the cap chip 120 are both visible and detectable through known techniques - for example, by X-ray microscope reading.

The use of an index formed by two portions 205, 210 distributed on two different chips 115, 120 is advantageous since such index portions 205, 210, being suitable to be located in arbitrary position within the corresponding chip 115, 120, are arranged in such a way to exploit pre-existing areas (possibly unused) of the chip 115, 120 without the excessive length of the index being incompatible with the demands of miniaturization of the MEMS device 400. In this way, the minimizing of the size of the chips 115, 120, and hence of the whole MEMS device 400, is not penalized.

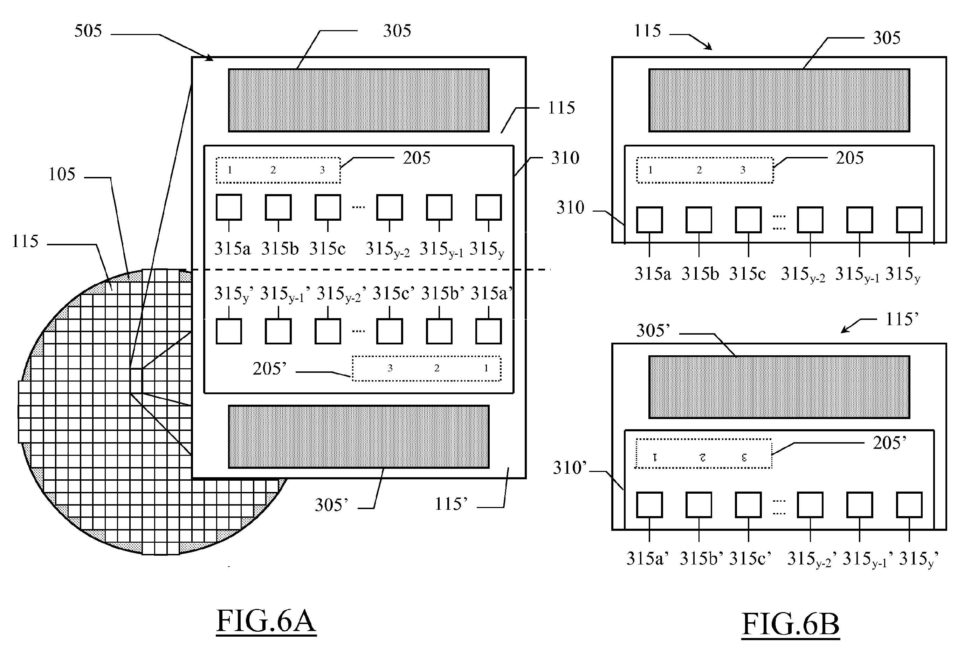

In FIG.6A and 6B there is shown an implementation of the indexing method of FIG.2 according to another embodiment of the present invention.

In particular, in FIG.6A there is again shown the sensor wafer 105 with a plurality of sensor chips 115 that are arranged in the sensor wafer 105 in another manner known in the state of the art.

Such embodiment differs from that shown in FIG.3 substantially by the different mutual orientation of two (or more) adjacent sensor chips 115. The sensor chips are distributed on the sensor wafer 105 in such a way that each sensor chip 115 is rotated by 180° with respect to the immediately preceding sensor chip and the immediately following sensor chip, and with respect to the sensor chip immediately above and the sensor chip immediately below. In particular, as shown in FIG.6A for a generic and exemplary pair 505 of sensor chips 115 and 115', the sensor chip 115 is rotated by 180° with respect to the adjacent sensor chip 115' below it (hereinafter, the components of the sensor chip 115' are indicated with the same references of the corresponding components of the sensor chip 115 with the addition of an apex). Such structure is commonly implemented for avoiding possible breakages of the sensor wafer 105; in fact, since the sensor chips 115, 115' have areas of different weight (the active section 305, 305', the terminal section 310, 310' and an unused area), an identical arrangement of the sensor chips 115, 115' on the sensor wafer 105 may cause structural damages of the sensor wafer 105 itself since the weight of all the sensor chips 115, 115' is not distributed uniformly on the sensor wafer 105 but it is concentrated in certain areas thereof.

In such case, in an embodiment of the invention, it is possible to write a first index portion 205 on first three contacts 315a, 315b, 315c of the sensor chip 115 (in the sensor wafer 105, from left to right, at the top), and a first index portion 205' having the same digits of the first index portion 205 on first three contacts 315a', 315b', 315c' of the sensor chip 115' (in mirrored position in the sensor wafer 105, from right to left, at the bottom).

During reading of the index on the sensor chips 115 and 115' being formed by cutting each pair 505 along its own axis (dashed line in FIG.6A), an arbitrary predefined common orientation is assumed, as shown in FIG.6B. In the example in the figure, the reading of the index is performed by placing the sensor chip 115, 115' with the corresponding terminals section 310, 310' oriented downward; in this way, the sensor chip 115 is marked by the index portion 205 (on the first three contacts 315a, 315b, 315c) having value 123, so that it will be read as the one-hundred-twenty-third sensor chip 115 within the corresponding area of the sensor wafer 105; instead, the sensor chip 115' is marked by the index portion 205', which is in the same position on the first three contacts 315a', 315b', 315c' once arranged according to the predefined common orientation chosen for the reading of the index. The index portion 205' has again the value 123, but with the corresponding digits over-turned vertically; therefore, such value will be read as a different position of the sensor chip 105' within the corresponding area of the sensor wafer 105 (for example, equal to the value of the index portion 205 added to the half of the sensor chips formed within the area of the sensor wafer 105).

The proposed solution is advantageous since the use of over-turned alphanumeric characters allows achieving a doubling of the number of indexable electronic devices with the same number of characters: in particular, each index, including at least two possible orientations, allows indexing at least two electronic devices.

Naturally, in order to satisfy local and specific requirements, a person skilled in the art may apply to the solution described above many logical and/or physical modifications and alterations. More specifically, although the present invention has been described with a certain degree of particularity with reference to preferred embodiment(s) thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a matter of general design choice.

For example, the solution according to an embodiment of the invention lends itself to be implemented with an equivalent method (by using similar steps, removing some steps being non-essential, or adding further optional steps); moreover, the steps may be performed in a different order, concurrently or in an interleaved way (at least in part). Particularly, nothing prevents from forming the sensors chips and the cap chips directly (by dicing the sensor wafer and the cap wafer, respectively), and then coupling each cap chip with the corresponding sensor chip individually.

Similar considerations apply if the index includes more than two portions, properly distributed on the two chips.

Moreover, nothing prevents that the electronic device includes more than two chips coupled to each other (each one, or some but not all of them, including a corresponding index portion).

The same considerations apply if the index portions implement a different coordinate system, for example a mapping of the chip, or if such coordinates are written with non-alphanumeric characters, for example using Morse or Braille codes.

Nothing prevents that the index portions are formed by numerical characters in a non-decimal base (for example, in hexadecimal base), or by alphanumeric characters, including, for example, the ten numbers form 0 to 9 and the twenty-one letters from A to Z, for increasing the number of indexable devices.

The index may be distributed on two chips in any other way (for example, in case of an index that identifies the absolute position of the chip in the wafer, it is possible to write its most significant digits on a chip and its least significant digits on the other chip).

Although the proposed solution has been described with reference to electronic devices whose chips are formed one in stepper shot mode and the other in one shot mode, this should not be interpreted in a limitative way (with the same solution that may be applied even when the two chips are both formed in stepper shot or one shot mode). Moreover, such solution may be applied even in case of use of different lithographic techniques.

The proposed solution lends itself to be applied to any other type of electronic device (including electronic devices being not of the MEMS type).

The same considerations apply if the arrangement of the index portions is different; for example, they may be arranged on more free areas of the chip in order to maximize the exploitation of the area of the chip and to avoid possible damages of the contacts when writing the index. Alternatively, the indexes (or parts thereof) may also be not directly visible; in this case, the indexes are read with non-optical techniques (for example, echo-techniques when they are defined by corresponding notches).

In any case, it is possible to produce the electronic device in a different way. For example, nothing prevents removing part of the cap wafer with other techniques, or forming the recesses with different shape, size and/or depth (for example, with the recesses that may have the same depth when a localized planarization operation is performed). Alternatively, it is also possible to form a through-hole on each cap chip (when in the cap wafer), so as to leave the terminals section of the corresponding sensor chip directly uncovered when the cap wafer is coupled with the sensor wafer.

The feature of using same index portions with different reciprocal orientation may be applied to groups of more chips (for example, four); similarly, same index portions may be diversified by other orientations of the digits included therein (for example, by rotating the digits by 90°, 180° and 270° on different chips), or by combinations thereof.

Similar considerations apply if the electronic devices have a different structure or include equivalent components (either separately or in combination to each other). In particular, the proposed solution is not limited to the material of the wafer (in this case, silicon), but it may be applied to chips made on substrates of any other material (for example, quartz and plastic).

It should be readily apparent that the proposed structure might be part of the design of an integrated circuit. The design may also be created in a programming language; moreover, if the designer does not fabricate chips or masks, the design may be transmitted by physical means to others. In any case, the resulting integrated circuit may be distributed by its manufacturer in raw wafer form, as a bare die, or in packages. Moreover, the proposed electronic device may be mounted in intermediate products (such as mother boards) and coupled with one or more other chips (such as a processor or a memory). In any case, the integrated circuit is suitable to be used in complex systems (such as logic computers).

## Claims

1. A method for indexing electronic devices (400), the method including the steps of:
forming a plurality of first chips (115, 115') in a first wafer (105).
forming a plurality of second chips (120) in a second wafer (110),
forming a plurality of electronic devices (400) by coupling each first chip (115, 115') with a corresponding second chip (120), and
forming an index on each electronic device (400), the index being indicative of a position of the corresponding first chip (115, 115') in the first wafer (105) and composed of a first index portion (205, 205') and a second index portion (210),
**characterized in that**
the step of forming an index on each electronic device (400) comprises
forming the first index portion (205, 205') on each first chip (115, 115'), the first chip (115, 115') lacking a second index portion necessary for indicating the position of the first chip (115, 115') in the first wafer (105) , and
forming the second index portion (210) on each second chip (120), the second chip (120) lacking a first index portion necessary for indicating the position of the first chip (115, 115') in the first wafer (105).

2. The method according to claim 1, wherein the first wafer (105) includes a plurality of equal areas (125) each one including a subset (130) of the first chips (115, 115'), the first index portion (205, 205') being indicative of a position of the first chip (115,115') in the corresponding area (125) and the second index portion (210) being indicative of a position of the corresponding area (125) in the first wafer (105).

3. The method according to claim 2, wherein the step of forming a plurality of first chips (115, 115') includes:
forming the first chips (115, 115') of each subset (130) concurrently in the corresponding area (125), the subsets (130) being formed in succession in the first wafer (105),
wherein the step of forming a plurality of second chips (120) includes:
forming the second chips (120) concurrently in the second wafer (110),
wherein the step of forming a plurality of electronic devices (400) includes:
forming a composite wafer by joining each first chip (115, 115') of the first wafer (105) to the corresponding second chip (120) of the second wafer (110), and
forming each electronic device (400) by cutting the corresponding joined first chip (115, 115') and second chip (120) from the composite wafer,
wherein the step of forming a first index portion (205, 205') includes
forming the first index portions (205, 205') on the first chips (115, 115') of each subset (130) concurrently, the first index portions (205, 205') of the subsets (130) being formed in succession in the first wafer (105), and
wherein the step of forming a second index portion (210) includes:
forming the second index portions (210) on the second chips (120) concurrently in the second wafer (110).

4. The method according to any of the preceding claims, wherein each electronic device (400) is a Micro-Electro-Mechanical device, the first chip (115, 115') of the electronic device (400) including sensor means and the second chip (120) of the electronic device (400) including a cover for protecting the sensor means.

5. The method according to any of the preceding claims, wherein for each electronic device (400) the second chip (120) covers a functional area (305,305') of the first chip (115, 115'), the first index portion (205, 205') being included in a terminal area (310, 310') of the first chip (115, 115') being not covered by the second chip (120).

6. The method according to claim 5, wherein the step of forming a plurality of electronic devices (400) includes:
forming a recess (405) and a further recess (410) on each second chip (120) in the second wafer (110),
coupling the first wafer (105) with the second wafer (110), the recess (405) and the further recess (410) of each second chip (120) covering the functional area (305, 305') and the terminal area (310, 310'), respectively, of the corresponding first chip (115,115') , and
removing part of the second wafer (110) until reaching the further recess (410) of each second chip (120) thereby uncovering the terminal area (310, 310') of the corresponding first chip (115, 115') .

7. The method according to claim 6, wherein the step of removing part of the second wafer (110) is localised to selectively remove part of each second chip (120) associated with the corresponding further recess (410).

8. The method according to claim 6, wherein each further recess (410) is deeper than each recess (405), the step of removing part of the second wafer (110) including planarizing the second wafer (110) without reaching the recess (405), the step of forming a second index portion (210) on the second chip (120) being performed after said planarizing of the second wafer (110).

9. The method according to any of the preceding claims,
wherein the step of forming a plurality of first chips (115, 115') includes:
forming the first chips (115, 115') in groups (505) , each first chip (115, 115') of each group (505) having an orientation different from the orientation of each other adjacent first chip (115, 115') of the group (505) in the first wafer (105); and
wherein the step of forming a first index portion (205, 205') includes:
forming the first index portion (205,205') on the first chips (115, 115') of each group (505) with a common value, the first index portion (205, 205') of each first chip (115, 115') of the group (505) being formed with an orientation in the first chip (115, 115') different from the orientation of the first index portion (205,205') in each other first chip (115, 115') of the group (505) when the first chips (115, 115') of the group (505) are arranged according to a predefined common orientation for reading the first index portion (205,205').

10. The method according to claim 9, wherein the step of forming the first chips (115, 115') in groups (505), includes:
forming the first chips (115, 115') in pairs (505) of two first chips (115, 115'), the two first chips (115, 115') of each pair (505) being rotated by 180° with respect to each other.

11. The method according to claim 10, wherein the first index portion (205, 205') includes at least one digit, the step of forming the first index portion (205, 205') on the first chips (115, 115') of each group (505) including:
forming each digit of the first index portion (205, 205') on each first chip (115, 115') of the group (505) overturned with respect to the corresponding digit of each other first chip (115, 115') of the group (505).

12. The method according to any claim from 9 to 11, wherein the predefined common orientation includes an orientation of a set of contacts (315a-315y, 315a'-315y') of each first chip (115, 115').

## Patentansprüche

1. Verfahren zum Indexieren von elektronischen Vorrichtungen (400), wobei das Verfahren folgende Schritte aufweist:
Bilden einer Mehrzahl von ersten Chips (115, 115') in einem ersten Wafer (105),
Bilden einer Mehrzahl von zweiten Chips (120) in einem zweiten Wafer (110),
Bilden einer Mehrzahl von elektronischen Vorrichtungen (400) unter Kopplung jedes ersten Chips (115, 115') mit einem entsprechenden zweiten Chip (120), und
Bilden eines Indexes an jeder elektronischen Vorrichtung (400), wobei der Index eine Position des entsprechenden ersten Chips (115, 115') in dem ersten Wafer (105) anzeigt sowie aus einem ersten Indexbereich (205, 205') und einem zweiten Indexbereich (210) gebildet ist,
**dadurch gekennzeichnet, dass** der Schritt des Bildens eines Indexes an jeder elektronischen Vorrichtung (400) beinhaltet:
Bilden des ersten Indexbereichs (205, 205') an jedem ersten Chip (115, 115'), wobei dem ersten Chip (115, 115') ein zweiter Indexbereich fehlt, der zum Anzeigen der Position des ersten Chips (115, 115') in dem ersten Wafer (105) notwendig ist, und
Bilden des zweiten Indexbereichs (210) an jedem zweiten Chip (120), wobei dem zweiten Chip (120) ein erster Indexbereich fehlt, der zum Anzeigen der Position des ersten Chips (115, 115') in dem ersten Wafer (105) notwendig ist.

2. Verfahren nach Anspruch 1,
wobei der erste Wafer (105) eine Mehrzahl von gleichen Bereichen (125) aufweist, die jeweils eine Teilmenge (130) der ersten Chips (115, 115') beinhalten,
wobei der erste Indexbereich (205, 205') eine Position des ersten Chips (115, 115') in dem entsprechenden Bereich (125) anzeigt und der zweite Indexbereich (210) eine Position des entsprechenden Bereichs (125) in dem ersten Wafer (105) anzeigt.

3. Verfahren nach Anspruch 2,
wobei der Schritt des Bildens einer Mehrzahl von ersten Chips (115, 115') beinhaltet:
Bilden der ersten Chips (115, 115') von jeder Teilmenge (130) gleichzeitig in dem entsprechenden Bereich (125),
wobei die Teilmengen (130) in dem ersten Wafer (105) nacheinander gebildet werden,
wobei der Schritt des Bildens einer Mehrzahl von zweiten Chips (120) beinhaltet:
Bilden der zweiten Chips (120) gleichzeitig in dem zweiten Wafer (110),
wobei der Schritt des Bildens einer Mehrzahl von elektronischen Vorrichtungen (400) beinhaltet:
Bilden eines Verbund-Wafers durch Verbinden jedes ersten Chips (115, 115') des ersten Wafers (105) mit dem entsprechenden zweiten Chip (120) des zweiten Wafers (110), und
Bilden jeder elektronischen Vorrichtung (400) durch spanendes Trennen des entsprechenden verbunden ersten Chips (115, 115') und zweiten Chips (120) von dem Verbund-Wafer,
wobei der Schritt des Bildens eines ersten Indexbereichs (205, 205') beinhaltet:
Bilden der ersten Indexbereiche (205, 205') an den ersten Chips (115, 115') jeder Teilmenge (130) in gleichzeitiger Weise, wobei die ersten Indexbereiche (205, 205') der Teilmengen (130) in dem ersten Wafer (105) nacheinander gebildet werden, und
wobei der Schritt des Bildens eines zweiten Indexbereichs (210) beinhaltet:
Bilden der zweiten Indexbereiche (210) an den zweiten Chips (120) gleichzeitig in dem zweiten Wafer (110).

4. Verfahren nach einem der vorhergehenden Ansprüche,
wobei jede elektronische Vorrichtung (400) eine mikroelektromechanische Vorrichtung ist, wobei der erste Chip (115, 115') der elektronischen Vorrichtung (400) eine Sensoreinrichtung aufweist und der zweite Chip (120) der elektronischen Vorrichtung (400) eine Abdeckung zum Schützen der Sensoreinrichtung aufweist.

5. Verfahren nach einem der vorhergehenden Ansprüche,
wobei für jede elektronische Vorrichtung (400) der zweite Chip (120) einen Funktionsbereich (305, 305') des ersten Chips (115, 115') bedeckt, wobei der erste Indexbereich (205, 205') in einem Anschlussbereich (310, 310') des ersten Chips (115, 115') enthalten ist , der nicht von dem zweiten Chip (120) bedeckt ist.

6. Verfahren nach Anspruch 5,
wobei der Schritt des Bildens einer Mehrzahl von elektronischen Vorrichtungen (400) beinhaltet:
Bilden eine Aussparung (405) und einer weiteren Aussparung (410) an jedem zweiten Chip (120) in dem zweiten Wafer (110),
Koppeln des ersten Wafers (105) mit dem zweiten Wafer (110), wobei die Aussparung (405) und die weitere Aussparung (410) jedes zweiten Chips (120) den Funktionsbereich (305, 305') bzw. den Anschlussbereich (310, 310') des entsprechenden ersten Chips (115, 115') überdecken, und
Entfernen eines Teils des zweiten Wafers (110) bis zum Erreichen der weiteren Aussparung (410) jedes zweiten Chips (120), um dadurch den Anschlussbereich (310, 310') des entsprechenden ersten Chips (115, 115') freizulegen.

7. Verfahren nach Anspruch 6,
wobei der Schritt des Entfernens eines Teils des zweiten Wafers (110) lokalisiert ist, um selektiv einen Teil von jedem zweiten Chip (120) zu entfernen, der der entsprechenden weiteren Aussparung (410) zugeordnet ist.

8. Verfahren nach Anspruch 6,
wobei jede weitere Aussparung (410) tiefer ist als jede Aussparung (405), wobei der Schritt des Entfernens eines Teils des zweiten Wafers (110) das Einebnen des zweiten Wafers (110) ohne Erreichen der Aussparung (405) beinhaltet,
wobei der Schritt des Bildens eines zweiten Indexbereichs (210) an dem zweiten Chip (120) nach dem Einebnen des zweiten Wafers (110) ausgeführt wird.

9. Verfahren nach einem der vorhergehenden Ansprüche,
wobei der Schritt des Bildens einer Mehrzahl von ersten Chips (115, 115') beinhaltet:
Bilden der ersten Chips (115, 115') in Gruppen (505), wobei jeder erste Chip (115, 115') jeder Gruppe (505) eine andere Ausrichtung aufweist als die Ausrichtung von jedem anderen benachbarten ersten Chip (115, 115') der Gruppe (505) in dem ersten Wafer (105) aufweist; und
wobei der Schritt des Bildens eines ersten Indexbereichs (205, 205') beinhaltet:
Bilden des ersten Indexbereichs (205, 205') an den ersten Chips (115, 115') jeder Gruppe (505) mit einem gemeinsamen Wert, wobei der erste Indexbereich (205, 205') jedes ersten Chips (115, 115') der Gruppe (505) mit einer Ausrichtung in dem ersten Chip (115, 115') gebildet wird, die sich von der Ausrichtung des ersten Indexbereichs (205, 205') in jedem anderen ersten Chip (115, 115') der Gruppe (505) unterscheidet, wenn die ersten Chips (115, 115') der Gruppe (505) gemäß einer vordefinierten gemeinsamen Ausrichtung zum Lesen des ersten Indexbereichs (205, 205) angeordnet sind.

10. Verfahren nach Anspruch 9,
wobei der Schritt des Bildens der ersten Chips (115, 115') in Gruppen (505) beinhaltet:
Bilden (500) der ersten Chips (115, 115') in Paaren (505) von zwei ersten Chips (115, 115'),
wobei die beiden ersten Chips (115, 115') jedes Paares (505) relativ zueinander um 180° verdreht sind.

11. Verfahren nach Anspruch 10,
wobei der erste Indexbereich (205, 205') mindestens eine Ziffer umfasst, wobei der Schritt des Bildens des ersten Indexbereichs (205, 205') an den ersten Chips (115, 115') jeder Gruppe (505) beinhaltet:
Bilden jeder Ziffer des ersten Indexbereichs (205, 205') an jedem ersten Chip (115, 1215') der Gruppe (505) in gekippter Weise in Bezug auf die entsprechende Ziffer von jedem anderen ersten Chip (115, 115') der Gruppe (505).

12. Verfahren nach einem der Ansprüche 9 bis 11,
wobei die vordefinierte gemeinsame Ausrichtung eine Ausrichtung eines Satzes von Kontakten (315a-315y, 315a'-315y') jedes ersten Chips (115, 115') umfasst.

## Revendications

1. Procédé d'indexation de dispositifs électroniques (400), le procédé comprenant les étapes consistant à :
former une pluralité de premières puces (115, 115') sur une première tranche (105),
former une pluralité de secondes puces (120) sur une seconde tranche (110),
former une pluralité de dispositifs électroniques (400) en couplant chaque première puce (115, 115') à une seconde puce correspondante (120), et
former un repère sur chaque dispositif électronique (400), le repère étant indicatif d'une position de la première puce correspondante (115, 115') sur la première tranche (105) et se composant d'une première partie repère (205, 205') et d'une seconde partie repère (210),
**caractérisé en ce que** :
l'étape de formation d'un repère sur chaque dispositif électronique (400) comprend :
la formation de la première partie repère (205, 205') sur chaque première puce (115, 115'), la première puce (115, 115') étant dépourvue d'une seconde partie repère nécessaire pour indiquer la position de la première puce (115, 115') sur la première tranche (105), et
la formation de la seconde partie repère (210) sur chaque seconde puce (120), la seconde puce (120) étant dépourvue d'une première partie repère nécessaire pour indiquer la position de la première puce (115, 115') sur la première tranche (105).

2. Procédé selon la revendication 1, dans lequel la première tranche (105) comporte une pluralité de zones égales (125) comportant chacune un sous-ensemble (130) des premières puces (115, 115'), la première partie repère (205, 205') indiquant une position de la première puce (115', 115') dans la zone correspondante (125) et la seconde partie repère (210) indiquant une position de la zone correspondante (125) sur la première tranche (105).

3. Procédé selon la revendication 2, dans lequel l'étape de formation d'une pluralité de premières puces (115, 115') comprend :
la formation simultanée des premières puces (115, 115') de chaque sous-ensemble (130) dans la zone correspondante (125), les sous-ensembles (130) étant formés successivement sur la première tranche (105),
dans lequel l'étape de formation d'une pluralité de secondes puces (120) comprend :
la formation simultanée des secondes puces (120) sur la seconde tranche (110),
dans lequel l'étape de formation d'une pluralité de dispositifs électroniques (400) comprend :
la formation d'une tranche composite par jonction de chaque première puce (115, 115') de la première tranche (105) à la seconde puce correspondante (120) de la seconde tranche (110), et
la formation de chaque dispositif électronique (400) par découpage des première (115, 115') et seconde (120) puces correspondantes jointes, dans la plaquette composite,
dans lequel l'étape de formation d'une première partie repère (205, 205') comprend :
la formation simultanée des premières parties repères (205, 205') sur les premières puces (115, 115') de chaque sous-ensemble (130),
les premières parties repères (205, 205') des sous-ensembles (130) étant formées successivement sur la première tranche (105), et
dans lequel l'étape de formation d'une seconde partie repère (210) comprend :
la formation simultanée des secondes parties repères (210) sur les secondes puces (120) de la seconde tranche (110).

4. Procédé selon l'une quelconque des revendications précédentes, dans lequel chaque dispositif électronique (400) est un dispositif microélectromécanique, la première puce (115, 115') du dispositif électronique (400) comportant un moyen formant capteur et la seconde puce (120) du dispositif électronique (400) comportant un couvercle de protection du moyen formant capteur.

5. Procédé selon l'une quelconque des revendications précédentes, dans lequel pour chaque dispositif électronique (400) la seconde puce (120) recouvre une zone fonctionnelle (305, 305') de la première puce (115, 115'), la première partie repère (205, 205') étant incluse dans une zone de bornes (310, 310') de la première puce (115, 115'), qui n'est pas recouverte par la seconde puce (120).

6. Procédé selon la revendication 5, dans lequel l'étape de formation d'une pluralité de dispositifs électroniques (400) comprend :
la formation d'un évidement (405) et d'un évidement supplémentaire (410) sur chaque seconde puce (120) de la seconde tranche (110),
le couplage de la première tranche (105) à la seconde tranche (110), l'évidement (405) et l'évidement supplémentaire (410) de chaque seconde puce (120) recouvrant la zone fonctionnelle (305, 305') et la zone de bornes (310, 310'), respectivement, de la première puce correspondante (115, 115'), et
l'élimination d'une partie de la seconde tranche (110) jusqu'à ce que l'évidement supplémentaire (410) de chaque seconde puce (120) soit atteint, de manière à découvrir la zone de bornes (310, 310') de la première puce correspondante (115, 115').

7. Procédé selon la revendication 6, dans lequel l'étape d'élimination d'une partie de la seconde tranche (110) est localisée en vue de l'élimination sélective d'une partie de chaque seconde puce (120), associée à l'évidement supplémentaire (410).

8. Procédé selon la revendication 6, dans lequel chaque évidement supplémentaire (410) est plus profond que chaque évidement (405), l'étape d'élimination d'une partie de la seconde tranche (110) incluant la planarisation de la seconde tranche (110) sans atteindre l'évidement (405), l'étape de formation d'une seconde partie repère (210) sur la seconde puce (120) étant exécutée après ladite planarisation de la seconde tranche (110).

9. Procédé selon l'une quelconque des revendications précédentes, dans lequel l'étape de formation d'une pluralité de premières puces (115, 115') comprend :
la formation des premières puces (115, 115') par groupes (505), chaque première puce (115, 115') de chaque groupe (505) ayant une orientation différente de l'orientation de chaque autre première puce voisine (115, 115') du groupe (505) sur la première tranche (105) ; et
dans lequel l'étape de formation d'une première partie repère (205, 205') comprend :
la formation de la première partie repère (205, 205') sur les premières puces (115, 115') de chaque groupe (505) avec une valeur commune, la première partie repère (205, 205') de chaque première puce (115, 115') du groupe (505) étant formée selon une orientation sur la première puce (115, 115') différente de l'orientation de la première partie repère (205, 205') de chaque autre première puce (115, 115') du groupe (505), lorsque les premières puces (115, 115') du groupe (505) sont disposées selon une orientation commune prédéfinie pour la lecture de la première partie repère (205, 205').

10. Procédé selon la revendication 9, dans lequel l'étape de formation des premières puces (115, 115') par groupes (505) comprend :
la formation des premières puces (115, 115') par paires (505) de deux premières puces (115, 115'), les deux premières puces (115, 115') de chaque paire (505) étant tournées de 180° l'une par rapport à l'autre.

11. Procédé selon la revendication 10, dans lequel la première partie repère (205, 205') comporte au moins un chiffre, l'étape de formation de la première partie repère (205, 205') sur les premières puces (115, 115') de chaque groupe (505) comprenant :
la formation de chaque chiffre de la première partie repère (205, 205') sur chaque première puce (115, 115') du groupe (505), retourné par rapport au chiffre correspondant de chaque autre première puce (115, 115') du groupe (505).

12. Procédé selon l'une quelconque des revendications 9 à 11, dans lequel l'orientation commune prédéfinie inclut l'orientation d'un ensemble de contacts (315a à 315y, 315a' à 315y') de chaque première puce (115, 115').
